Europäisches Patentamt

European Patent Office

Office européen des brevets

(11) Veröffentlichungsnummer: **0 237 699 B1**

(12) **EUROPÄISCHE PATENTSCHRIFT**

(45) Veröffentlichungstag der Patentschrift: **03.06.92**

(51) Int. Cl.⁵: **H03L 7/08**

(21) Anmeldenummer: **87100202.8**

(22) Anmeldetag: **09.01.87**

(54) Verfahren und Schaltungsanordnung zum Synchronisieren eines insbesondere einer Vermittlungseinrichtung zugehörigen spannungsgesteuerten Oszillators.

(30) Priorität: **17.02.86 DE 3604965**

(43) Veröffentlichungstag der Anmeldung:
**23.09.87 Patentblatt 87/39**

(45) Bekanntmachung des Hinweises auf die
Patenterteilung:
**03.06.92 Patentblatt 92/23**

(84) Benannte Vertragsstaaten:
**AT BE CH DE ES FR GB GR IT LI LU NL SE**

(56) Entgegenhaltungen:
**FR-A- 2 294 587**
**US-A- 4 316 152**
**US-A- 4 458 214**

**ISS '81 CIC, Session 41A, Paper 8, Seiten 1-5,21-25, September 1981, Montreal, CA; F. GILLET et al.: "An implementation strategy for networks synchronization of digital exchange networks"**

(73) Patentinhaber: **Siemens Nixdorf Informations-systeme Aktiengesellschaft**
**Fürstenallee 7**
**W-4790 Paderborn(DE)**

(72) Erfinder: **Backhaus, Martin**
**D. Bonhoefferstrasse 33**
**W-4790 Paderborn(DE)**
Erfinder: **Hubert, Christian**
**Brandisstrasse 23**
**W-4790 Paderborn(DE)**

(74) Vertreter: **Fuchs, Franz-Josef, Dr.-Ing. et al**
**Postfach 22 13 17**
**W-8000 München 22(DE)**

EP 0 237 699 B1

**Beschreibung**

Die Erfindung bezieht sich auf ein Verfahren nach dem Oberbegriff des Patentanspruchs 1 und eine Schaltungsanordnung nach dem Oberbegriff des Patentanspruchs 3.

Ein Verfahren und eine Schaltungsanordnung der vorstehend bezeichneten Art sind bereits bekannt (Tagungsband vom ISS' 81, CIC Montreal, 22 bis 25. September 1981, Session 41, Paper 8 "An Implementation Strategy for Networks Synchronization of Digital Exchange Networks"). Von Nachteil bei dem bekannten Verfahren der zu dessen Durchführung dienenden Schaltungsanordnung ist jedoch der recht große Schaltungsaufwand, der vorgesehen ist, um eine Synchronisierung des vorhandenen Oszillators auf externe Taktimpulse mit unterschiedlichsten Taktraten zu ermöglichen. In diesem Zusammengang ist aus der US-A-4 458 214 auch bekannt, in einer Meßeinrichtung, die interne und externe Taktimpulse untereinander vergleicht, die internen Taktimpulse mit einem Zähler ständig zu zählen.

Der Erfindung liegt die Aufgabe zugrunde, einen Weg zu zeigen, wie auf einfache Weise und mit insgesamt relativ geringem Aufwand ein spannungsgesteuerter Oszillator mit Hilfe von externen Taktimpulsen synchronisiert werden kann, die mit einer Bitrate aus einer Vielzahl von unterschiedlichen vorgegebenen Bitraten auftreten.

Gelöst wird die vorstehend aufgezeigte Aufgabe bei einem Verfahren der eingangs genannten Art erfindungsgemäß durch die im kennzeichnenden Teil des Anspruchs 1 angegebenen Maßnahmen.

Die Erfindung bringt den Vorteil mit sich, daß auf einfache Weise eine sichere Synchronisierung des spannungsgesteuerten Oszillators durch externe Taktimpulse möglich ist, die jeweils mit einer Bitrate aus einer Vielzahl von vorgegebenen Bitraten auftreten. Dabei ist es durch die zunächst erfolgende Ermittlung der Bitrate der externen Taktimpulse und der sodann erfolgenden Ermittlung eines Phasenreferenzwertes besonders einfach möglich, anschließend den spannungsgesteuerten Oszillator im gewünschten Sinne zu synchronisieren.

Bei Ausgestaltung des Verfahren gemäß der Erfindung in der im Anspruch 2 angegebenen Weise ergibt sich der Vorteil einer besonders einfachen Bildung einer Steuerspannung für den Oszillator.

Zur Durchführung des Verfahrens gemäß der Erfindung dient vorzugsweise eine Schaltungsanordnung, wie sie im Anspruch 3 angegeben ist.

Hierdurch wird der Vorteil erzielt, daß mit insgesamt relativ geringem schaltungstechnischen Aufwand der vorhandene spannungsgesteuerte Oszillator mit Hilfe von externen Taktimpulsen synchronisiert werden kann, die mit einer Bitrate auftreten, welche irgendeinen Wert aus einer Vielzahl von unterschiedlichen vorgegebenen Werten aufweist. Beim Anlegen des externen Taktes kann dessen Phasenlage in bezug zum internen Takt beliebig sein, ohne daß es dadurch zu einem Phasensprung (Jittern) des internen nachgeregelten Taktes kommt. Es wird mit einem einfachen Zähler und einer relativ einfach realisierbaren Steuereinrichtung ausgekommen, um die gewünschte Synchronisierschaltung aufzubauen.

Bei Ausgestaltung der vorstehend genannten Schaltungsanordnung gemäß der Erfindung in der im Anspruch 4 angegebenen Weise ergibt sich der Vorteil eines besonders geringen schaltungstechnischen Aufwands hinsichtlich der Erzeugung einer Einstellgröße für den Oszillator.

Bei Ausgestaltung der Schaltungsanordnung gemäß der Erfindung in der im Anspruch 5 angegebenen Weise ergibt sich der Vorteil eines besonders geringen schaltungstechnischen Aufwands hinsichtlich der Steuereinrichtung.

Bei Ausgestaltung der Schaltungsanordnung gemäß der Erfindung in der im Anspruch 6 angegebenen Weise ergibt sich der Vorteil einen besondere sicheren Betriebs der Meßeinrichtung.

Bei Ausgestaltung der Schaltungsanordnung gemäß der Erfindung in der im Anspruch 7 angegebenen Weise ergibt sich der Vorteil eines relativ geringen schaltungstechnischen Aufwands hinsichtlich der Ansteuerung der Latch-Registeranordnung.

Von Vorteil ist es schließlich, wenn die Schaltungsanordnung gemäß der Erfindung in der im Anspruch 8 angegebenen Weise ausgestaltet wird. Dadurch ergibt sich ein besonders geringer schaltungstechnischer Aufwand hinsichtlich der Ansteuerung der Latch-Registeranordnung.

Anhand von Zeichnungen wird die Erfindung nachstehend beispielsweise näher erläutert.

Fig. 1     zeigt in einem Blockschaltbild einen möglichen Aufbau einer Schaltungsanordnung gemäß der Erfindung.

Fig. 2     zeigt in einem Blockschaltbild einen weiteren Aufbau der Schaltungsanordnung gemäß der Erfindung.

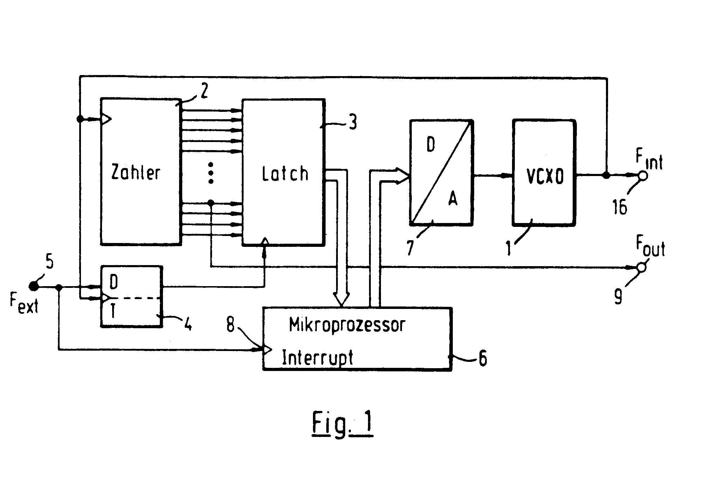

Die in Fig. 1 dargestellte Schaltungsanordnung gemäß der Erfindung weist einen spannungsgesteuerten Oszillator (VCXO) 1 auf, der insbesondere zu einer Vermittlungseinrichtung, und zwar einer digitalen Vermittlungseinrichtung gehören kann und der interne Taktimpulse mit einer ersten Bitrate bzw. Frequenz Fint abgibt, die beispielsweise 100 kbit/s bzw. 100 kHz betragen kann. Diese Taktimpulse werden an einem

2

EP 0 237 699 B1

Ausgang 16 (Fint) abgegeben. Der Oszillator 1, der durch externe Taktimpulse zu synchronisierung ist, kann in typischer Weise einen Regelbereich aufweisen, der kleiner ist als $10^{-4}$.

Zu der in Fig. 1 dargestellten Schaltungsanordnung gehört ferner eine Meßeinrichtung, zu der ein Zähler 2 mit nachgeschaltetem Latch-Register 3 und ein bistabiles Kippglied 4 gehören, bei dem es sich im vorliegenden Fall um ein D-Flipflop handelt. Der Zähler 2 ist mit seinem Zähleingang am Ausgang des Oszillators 1 angeschlossen; er Zählt ständig die von den Oszillator 1 abgegebenen Taktimpulse; er kann beispielsweise ein dekadisch zählender Zähler sein, der bis 10 000 zählt.

Das mit den Ausgängen des Zählers 2 verbundene Latch-Register 3 ist mit einem gesonderten Steuereingang am Ausgang des erwähnten D-Flipflops 4 angeschlossen. Diesem D-Flipflop werden an einem Takteingang T die internen Taktimpulse und an einem Dateneingang D die jeweiligen externen Taktimpulse zugeführt, die an einem Anschluß 5 auftreten und die jeweils mit einer Taktrate bzw. Frequenz aus einer Vielzahl von Taktraten bzw. Frequenzen (Fext) auftreten. Durch das D-Flipflop wird aus dem externen Takt ein Übernahmetakt für das Latch-Register 3 gebildet, so daß ein definiert gesetzter Zählerstand übernommen wird.

Zu der in Fig. 1 dargestellten Schaltungsanordnung gehört ferner eine Steuereinrichtung, die als wesentlichen Bestandteil einen Mikroprozessor bzw. Mikrocomputer 6 umfaßt, der mit seiner Signaleingangsseite am Ausgang des Latch-Registers 3 und mit seiner Signalausgangsseite über einen Digital-Analog-Wandler 7 an einem Steuereingang des spannungsgesteuerten Oszillators 1 angeschlossen ist. Der Mikroprozessor bzw. Mikrocomputer 6 ist ferner mit einem Steueranschluß 8, bei dem es sich in typischer Weise um einen sogenannten Unterbrechungseingang (Interrupt) handeln kann, an dem erwähnten Eingangsanschluß 5 angeschlossen, an dem die externen Taktimpulse auftreten.

Im Hinblick auf die in Fig. 1 dargestellte Schaltungsanordnung ist noch anzumerken, daß einer der Ausgänge des Zählers 2 mit einem Ausgangsanschluß 9 verbunden ist, an dem in der Taktrate bzw. Frequenz untersetzte Taktimpulse (Fout) auftreten, die von den internen Taktimpulsen abgeleitet sind, welche an Ausgangsanschluß 16 auftreten. Da der Zähler 2 eigentlich zu einer Meßeinrichtung gehört, deren Funktion weiter unten noch näher erläutert werden wird, ergibt sich somit der Vorteil, daß er zusätzlich für eine Taktraten- bzw. Frequenzuntersetzung mit ausgenutzt ist.

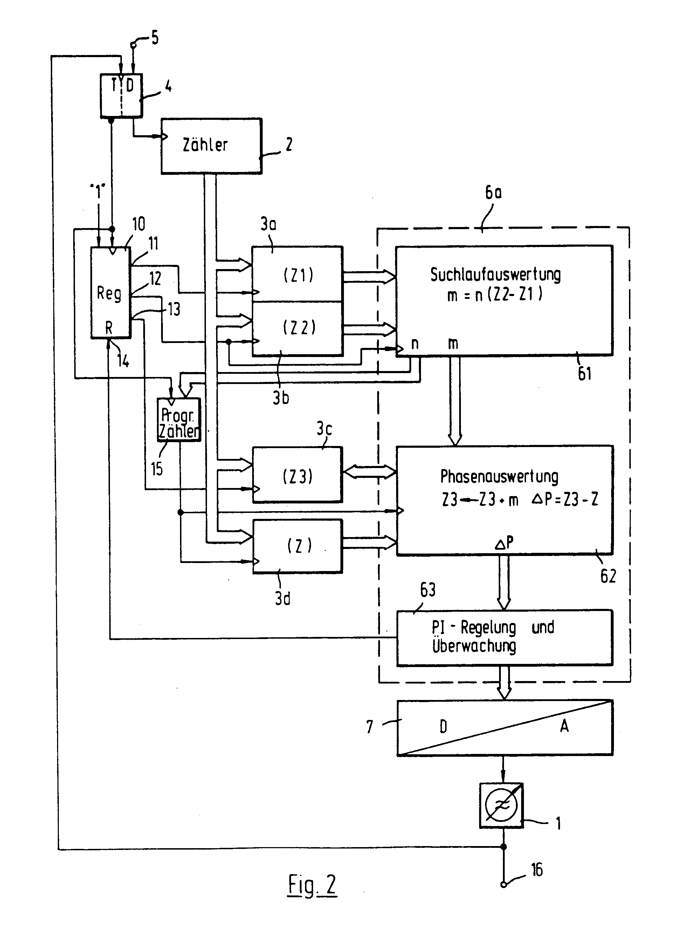

In Fig. 2 ist eine Schaltungsanordnung gezeigt, die als weitere Ausführungsform der Schaltungsanordnung gemäß der Erfindung oder als ein schaltungsmäßiges Abbild der in Fig. 1 dargestellten, einen Mikroprozessor bzw. Mikrocomputer enthaltenden Schaltungsanordnung aufgefaßt werden kann.

Gemäß Fig. 2 umfaßt die im Zusammenhang mit Fig. 1 erwähnte Meßeinrichtung den Zähler 2, die Latch-Registeranordnung 3a, 3b, 3c, 3d und das bistabile D-Flipflop 4, dem an seinem Dateneingang D die externen Taktimpulse von einem Anschluß 5 her und an einem Takteingang T die internen Taktimpulse von dem spannungsgesteuerten Oszillator 1 her zugeführt werden, der diese Taktimpulse an den Anschluß 16 abgibt. Die Steuereinrichtung ist in Fig. 2 mit 6a bezeichnet. Sie umfaßt einen der Suchlaufauswertung dienenden Schaltungsteil 61, einen der Phasenauswertung dienenden Schaltungsteil 62 und einen der PI-Regelung und Überwachung dienenden Schaltungsteil 63. Diese Schaltungsteile 61, 62 und 63 sind miteinander, mit der Latch-Registeranordnung 3a bis 3d, einem Steuerregister 10 und programmierbaren Zähler 15 verbunden. Auf die Funktionen der betreffenden Schaltungsteile wird weiter unten noch näher eingegangen werden.

Zu der in Fig. 2 dargestellten Schaltungsanordnung gehört ferner der im Zusammenhang mit Fig.1 erwähnte Digital-Anslog-Wandler 7, der zwischen dem Ausgang der Steuereinrichtung 6a und dem Steuereingang des spannungsgesteuerten Oszillators 1 vorgesehen ist. Außerdem weist die in Fig. 2 dargestellte Schaltungsanordnung das Steuerregister 10 auf, welches mit seinem Steuereingang an dem negierten Ausgang des D'Flipflops 4 und dem Schiebeeingang an logisch "1" angeschlossen ist. Dieses Register (Reg) 10 gibt an Ausgängen 11, 12, 13 Steuerimpulse an Takteingänge der Latch-Register 3a bzw. 3b bzw. 3c ab. Mit dem Steuerimpuls 12 wird auch die Suchlaufauswertung (61), und mit dem Steuerimpuls 13 wird die Phasenreferenzauswertung (62) eingeleitet (jeweils bei dem Wechsel von "0" zu "1"). Mit einem Rückstelleingang (R) 14 ist das betreffende Register 10 an einem Überwachungsausgang des erwähnten Schaltungsteiles 63 angeschlossen, so daß beispielsweise nach einem Ausfall des externen Taktes die Steuerung erneut initialisiert wird und ein neuer Suchlauf und Phasenreferenzwert ausgewertet werden.

Die in Fig. 2 dargestellte Schaltungsanordnung weist außerdem den bereits betrachteten Schaltungsteilen noch den programmierbaren Zähler 15 auf, der mit seiner Programmmierungs-Eingangsseite den mit n bezeichneten Parameter des Schaltungsteiles 61 übernimmt und mit einem Zähleingang an dem Ausgang des D-Flipflops 4 angeschlossen ist, an dem auch der Eingang des Registers 10 angeschlossen ist. Mit seinem Ausgang, der die Meßzeitpunkte festlegt, ist der programmierbare Zähler 15 mit einem Steuereingang des Schaltungsteiles 62 und mit einem Steuereingang des Latch-Registers 3d verbunden.

Im Hinblick auf die Ansteuerung der Steuereinrichtung 6a ist schließlich noch zu erwähnen, daß deren

3

EP 0 237 699 B1

Schaltungsteil 61 mit einem Steuereingang an dem Ausgang 12 des Registers 10 angeschlossen ist.

Im folgenden wird die Arbeitsweise der erfindungsgemäßen Schaltungsanordnung unter Bezugnahme auf die in Fig. 2 dargestellte Schaltungsanordnung erläutert. Diese Funktionsweise trifft ebenso auf die in Fig. 1 dargestellte Schaltungsanordnung zu.

Zunächst seien die Verhältnisse bezüglich der internen und externen Taktraten betrachtet, die hier berücksichtigt werden. Wie bereits erwähnt, liefert der bei der Schaltungsanordnung gemäß der Erfindung verwendete spannungsgesteuerte Oszillator 1 Taktimpulse mit einer Taktrate von beispielsweise 100 kbit/s bzw. 100 kHz. Dieser Oszillator 1 ist nun mit Taktraten zu synchronisieren, die unterschiedliche vorgegebene Werte haben können:

$$Fext = n \bullet F_1, \quad (1)$$

mit:

$n \quad = 1,2, ....$

$F_1 \quad = $ vorgegebener Frequenzschritt.

Wenn beispielsweise $F_1$ = 25 Hz ist, können Takte, wie 75 Hz, 300 Hz, 1,2 kHz, 2,4 kHz ..... synchronisiert werden. Zwischen der Taktrate der von dem Oszillator 1 erzeugten internen Taktimpulse (Fint) und der Taktrate der jeweiligen externen Taktimpulse (Fext) besteht dabei folgende Beziehung:

$$\frac{Fint}{Fext} = \frac{m}{n} \bullet \qquad (2)$$

hierin bedeutet m die Anzahl interner Taktimpulse und n die Anzahl externer Taktimpulse innerhalb ein und desselben Zeitraumes, der als Meßzeitspanne ausgenutzt wird. Aus (1) und (2) können die Meßzeitspanne und m berechnet werden:

$$Meßzeitspanne = \frac{m}{Fext} = \frac{1}{F_1}, \qquad (3)$$

$$m = \frac{Fint}{F_1} \quad (im \ Zahlenbeispiel: \ m = 4000). (4)$$

Um die Synchronisierung des Oszillators 1 vorzunehmen, sind zunächst eine Suchlaufauswertung, sodann eine Phasenauswertung und dann eine Regelung auszuführen.

Bei der Suchlaufauswertung wird zunächst die Taktrate bzw. Frequenz der externen Taktimpulse ermittelt. Dazu wird die Zählerstellung des Zählers 2 zu zwei aufeinanderfolgenden Zeitpunkten t1 und t2 ermittelt. Diese Zeitpunkte t1 und t2 sind in einem solchen zeitlichen Abstand voneinander entfernt, daß zwischen ihnen ein externer Taktimpuls auftritt. Die dem Zeitpunkt t1 entsprechende Zählerstellung (Z1) des Zählers 2 wird in dem Latch-Register 3a festgehalten, und die den Zeitpunkt t2 entsprechende Zählerstellung (Z2) des Zählers 2 wird in dem Latch-Register 3b festgehalten. Dabei genügen die zu den beiden Zeitpunkten t1 und t2 in den Latch-Registern 3a, 3b gespeicherten Zählerstellungen Z1 und Z2 der Beziehung

$$Z2 - Z1 = \frac{Fint}{Fext} \qquad (5)$$

Da die Größe m, also die Anzahl interner Taktimpulse, die während der Meßzeitspanne auftreten sollen, schon festgelegt wurde, kann die Anzahl n interner Taktimpulse bestimmt werden, die die Meßzeitspanne festlegt. Aus (2) und (5) folgt:

4

$$n = \frac{m}{Z2 - Z1} \cdot \qquad\qquad (6)$$

Der nach Beziehung (6) berechnete Parameter n wird auf eine Ganzzahl aufgerundet und in den programmierbaren Zähler 15 geladen. (Das Aufrunden ist erforderlich, um die Frequenzabweichung des internen oder externen Taktes zum Zeitpunkt des Suchlaufes auszugleichen und nur eine durch die Beziehung (1) vorgegebene externe Frequenz zuzulassen.)

Zu einem bezogen auf den erwähnten Zeitpunkt t2 nachfolgenden Zeitpunkt t3, der den Zeitpunkt t2 um die Dauer einer externen Taktperiode nachfolgt (das ist die zeitliche Differenz zwischen den Zeitpunkten t2 und t1), wird die Zählerstellung (Z3) des Zählers 2 in dem Latch-Register 3c übernommen. Diese Zählerstellung dient nun als aktueller Phasenreferenzwert, mit dem die externen Taktimpulse auftreten.

Zu dem Zeitpunkt t3 jeweils um die Dauer der Meßzeitspanne nachfolgenden Zeitpunkten wird der betreffende Phasenreferenzwert jeweils um m vergrößert (Z3 → Z3 + m). Sodann wird der jeweils aktuelle Phasenreferenzwert (Z3) mit der sodann vorliegenden Zählerstellung (Z - in dem Latch-Register 3d festgehalten) in Beziehung gesetzt, und zwar entsprechend der Subtraktion

$\Delta P = 23 - Z$ .     (7)

Die durch diese Beziehung ermittelte Größe $\Delta P$ stellt die Phasendifferenz zischen internen und externen Taktimpulsen dar. Eine dieser Größe entsprechende Steuerspannung wird dann zur Einstellung des spannungsgesteuerten Oszillators 1 herangezogen.

In die zuletzt erwähnte Ansteuerung des Oszillators 1 ist, wie dies aus Fig. 2 hervorgeht, noch der Schaltungsteil 63 einbezogen, der sowohl eine Proportional-Integral-Regelung als auch eine Überwachung vornimmt.

Im Rahmen der Proportional-Integral-(PI)-Regelung wird zunächst mit kleiner Zeitkonstante und damit mit relativ großem Fangbereich gearbeitet. Sodann wird mit großer Zeitkonstante gearbeitet, was den Vorteil mit sich bringt, daß eine starke Unterdrückung von Phasenzittern (Jittern) der externen Taktimpulse erreicht ist.

Abschließend seien zur Verdeutlichung der vorliegenden Erfindung noch einige Zahlenbeispiele gegeben. Gegeben seien:
Fext =     n • 25 Hz (n = 1,2, ....),
Fint =     100 kHz, mit Regelbereich:$\pm 10^{-4}$
Fout =     100 Hz,
ein Zähler 2, der als Dezimalzähler ausgeführt ist und der bis 10 000 zählen kann. Aus diesen Vorgaben und der Beziehung (4) wird m berechnet:

$$m = \frac{100\ \text{kHz}}{25\ \text{Hz}} = 4000 .$$

Beim Suchlauf können sich folgende Zahlenwerte ergeben:
Z1 =     2500 (bei der ersten Flanke),
Z2 =     2600 (bei der zweiten Flanke).
Damit beträgt die Taktrate bzw. Frequenz der externen Taktimpulse, berechnet nach (5):
Fext = Fint/(Z2-Z1) = 100 kHz/(600-2500) = 1kHz.
Bei einer externen Taktrate von z.B. 1000 Bit/s bzw. 1000 Hz ergibt sich somit n nach (6):

$$n = \frac{4000}{2600-2500} = 40 .$$

Geht man nunmehr unter Berücksichtigung des oben angegebenen Beispiels davon aus, daß zum Zeitpunkt t1 die Zählerstellung Z1 (= 2500), daß zum Zeitpunkt t2 die Zählerstellung Z2 (= 2600) und daß zu dem Zeitpunkt t3 Z3 (= 2700) vorliegt, so laufen folgende Vorgänge ab: Zu einem Zeitpunkt t4 (der auf den Zeitpunkt t3 in dem zeitlichen Abstand entsprechend der Meßzeitspanne von n externen Takten bzw. Taktimpulsen folgt) wird als Zählerstellung des Zählers beispielsweise Z = 6701 bereitgestellt. Dabei ist angenommen, daß der von dem Oszillator 1 erzeugte interne Takt eine etwas höhere Frequenz als normal aufweist. In der Steuereinrichtung 6 wird nun als Phasenreferenzwert Z3 (t) als Sollwert folgender Wert bereitgestellt:

$$Z3(t) = Z3(t-1) + m = 2700 + 4000 = 6700.$$

In der Phasenauswertung wird nunmehr als Phasendifferenz $\Delta P$ folgendes ermittelt:

$$\Delta P = Z3 - Z = 6700 - 6701 = -1.$$

Eine dieser Phasendifferenz entsprechende Steuerspannung wird dem Oszillator 1 zugeführt, und zwar unter Berücksichtigung der PI-Regelung.

Zum nächsten Meß- bzw. Bewertungszeitpunkt wird der Zähler 2 - wenn man von einem bis 10 000 zählenden Dezimalzähler ausgeht - folgende Zählerstellung Z haben:

$$Z = 6701 + 4001 \rightarrow 702 \text{ (Überlauf über 10 000).}$$

In der Steuereinrichtung wird als aktueller Phasenreferenzwert folgender Sollwert bereitgestellt:

$$Z3 (t) = Z3 (t-1) + m = 6700 + 4000 \rightarrow 700$$

(Überlauf über 10 000).

Als Phasendifferenz ergibt sich somit eine Größe von

$$\Delta P = 700 - 702 = -2.$$

Eine dieser Phasendifferenz entsprechende Steuerspannung wird sodann dem Oszillator 1 als Steuer- bzw. Regelspannung zugeführt. Bei den nachfolgenden Meßzeitpunkten läuft das Verfahren so wie bisher dargestellt weiter und führt somit zu einer stetigen Nachregelung des Oszillators.

Abschließend sei noch angemerkt, daß die bei der Schaltungsanordnung gemäß der Erfindung verwendete Steuereinrichtung auch so ausgelegt sein kann, daß sie die Erzeugung der internen Taktimpulse mit der jeweils eingestellten Phasenlage in dem Fall weiter aufrecht erhält, daß die externen Taktimpulse ausgefallen oder gestört sind.

**Patentansprüche**

**1.** Verfahren zum Synchronisieren eines insbesondere einer Vermittlungseinrichtung zugehörigen spannungsgesteuerten Oszillators (1), der mit einer ersten Bitrate auftretende interne Taktimpulse erzeugt, mit Hilfe von externen Taktimpulsen, die mit einer zweiten Bitrate auftreten, welche irgendeinen Wert aus einer Vielzahl von unterschiedlichen vorgegebenen Werten hat, wobei mittels einer ein die internen Taktimpulse ständig zählenden Zähler (2) umfassenden Meßeinrichtung (2, 3, 4) die zwischen den internen Taktimpulsen und den jeweiligen externen Taktimpulsen bestehenden Phasenunterschiede gemessen werden und wobei mittels einer Steuereinrichtung (6, 7) dem Oszillator (1) ein dem jeweiligen Phasenunterschied zwischen internen und externen Taktimpulsen entsprechende Steuerspannung zu einer solchen Einstellung zugeführt wird, daß die von dem Oszillator (1) erzeugten internen Taktimpulse in einer festgelegten Phasenbeziehung zu den jeweiligen externen Taktimpulsen auftreten, dadurch **gekennzeichnet**, daß zu eine bestimmte Suchlaufzeitspanne festlegenden Zeitpunkten die Zählerstellungen (Z1, Z2) des Zählers (2) von der Steuereinrichtung (6, 7) entsprechend der Beziehung

$$m = n (Z2 - Z1)$$

verknüpft und aufgerundet werden, wobei Z1 und Z2 die Zählerstellungen des Zählers (2) zu Beginn und am Ende der genannten Suchlaufzeitspanne, n die Anzahl der die nachfolgende Meßzeitspanne festlegenden externen Taktimpulse und m die Anzahl der innerhalb der genannten Meßzeitspanne auftretenden internen Taktimpulse bedeuten, daß die Zählerstellung des Zählers (2) zu Beginn der genannten Meßzeitspanne als Phasenreferenzwert der Steuerschaltung (6, 7) zur Verfügung gestellt wird und daß zu dem zuletzt genannten Zeitpunkt jeweils um die Dauer der bestimmten Meßzeitspanne nachfolgenden Zeitpunkten der jeweils um m vergrößerte und sodann als aktueller Phasenreferenzwert bereitgehaltene Phasenreferenzwert mit der sodann jeweils vorliegenden Zählerstellung des Zählers (2) in Beziehung gesetzt wird, deren Ergebnis zur Abgabe einer ihrer Größe entsprechenden Steuerspannung für den Oszillator (1) herangezogen wird.

2. Verfahren nach Anspruch 1, dadurch **gekennzeichnet**, daß der jeweilige berechnete aktuelle Phasenreferenzwert mit der jeweils vorliegenden Zählerstellung einer Subtraktion unterzogen wird.

3. Schaltungsanordnung zum Synchronisieren eines inbesondere einer Vermittlungseinrichtung zugehörigen spannungsgesteuerten Oszillators (1), der mit einer ersten Bitrate auftretende interne Taktimpulse erzeugt, mit Hilfe von externen Taktimpulsen, die mit einer zweiten Bitrate auftreten, welche irgendeinen Wert aus einer Vielzahl von unterschiedlichen vorgegebenen Werten hat, mit einer einen die internen Taktimpulse ständig zählenden Zähler (2) umfassenden Meßeinrichtung (2, 3, 4) für die zwischen den internen Taktimpulsen und den jeweiligen externen Taktimpulsen bestehenden Phasenunterschiede und mit einer Steuereinrichtung (6, 7), die dem Oszillator (1) eine dem jeweiligen Phasenunterschied zwischen den internen und externen Taktimpulsen entsprechende Steuerspannung zuführt und ihn so einstellt, daß die von dem Oszillator (1) erzeugten internen Taktimpulse in einer festgelegten Phasenbeziehung zu den jeweiligen externen Taktimpulsen auftreten, dadurch **gekennzeichnet**, daß der Zähler (2) ausgangsseitig mit einer Latch-Registeranordnung (3; 3a bis 3d) verbunden ist, welche die zu in Abstand der bestimmtem Zeitspanne aufeinanderfolgenden Zeitpunkten vorhandenen Zählerstellungen des Zählers (2) übernimmt, daß die zu zwei derartigen aufeinanderfolgenden Zeitpunkten vorhandenen Zählerstellungen des Zählers (2) entsprechend der Beziehung

$$m = n (Z2 - Z1)$$

verknüpft und aufgerundet werden, wobei Z1 und Z2 die Zählerstellungen des Zählers (2) zu Beginn und am Ende der genannten Suchlaufzeitspanne, n die Anzahl der die nachfolgende Meßzeitspanne festlegenden externen Taktimpulse und m die Anzahl der innerhalb der genannten Meßzeitspanne auftretenden internen Taktimpulse bedeuten, daß die zu Beginn der genannten Meßzeitspanne gewonnene Zählerstellung des Zählers (2) als Phasenreferenzwert für eine Phasenauswertung dient, bei der jeweils zu um die Dauer der genannten Meßzeitspanne nachfolgenden weiteren Zeitpunkten dieser Phasenreferenzwert jeweils um m vergrössert mit der sodann jeweils vorliegenden Zählerstellung des Zählers (2) in Beziehung gesetzt wird und daß das Ergebnis dieser Beziehung als Einstellgröße für den Oszillator (1) dient.

4. Schaltungsanordnung nach Anspruch 3, dadurch **gekennzeichnet**, daß die zwischen der jeweils vorliegenden Zählerstellung des Zählers (2) und dem jeweils aktuell berechnetem phasenreferenzwert gebildete Beziehung eine Subtraktion ist.

5. Schaltungsanordnung nach Anspruch 3 oder 4, dadurch **gekennzeichnet**, daß die Steuereinrichtung (6, 7) einen Mikroprozessor oder Mikrocomputer (6) enthält, der durch die externen Taktimpulse gesteuert die Zählerstellungen des Zählers (2) übernimmt und der ausgangsseitig über einen Digital/Analog-Wandler (7) den Oszillator (1) steuert.

6. Schaltungsanordnung nach einem der Ansprüche 3 bis 5, dadurch **gekennzeichnet**, daß zwischen dem Zähler (2) und der Steuereinrichtung (6, 7) eine Latch-Registeranordnung (3; 3a bis 3d) vorgesehen ist.

7. Schaltungsanordnung nach Anspruch 6, dadurch **gekennzeichnet**, daß die Latch-Registeranordnung (3; 3a bis 3d) mit einer bistabilen Kippstufe (4) verbunden ist, die eingangsseitig sowohl die internen als auch die externen Taktimpulse zugeführt erhält.

8. Schaltungsanordnung nach Anspruch 7, dadurch **gekennzeichnet**, daß die bistabile Kippstufe (4) eine D-Kippstufe (4) ist, deren Takteingang die internen Taktimpulse und deren D-Eingang die externen Taktimpulse zugeführt sind.

**Claims**

1. A method of synchronising a voltage-controlled oscillator (1), more particularly an oscillator forming part of an exchange system and generating internal clock pulses at a first bit rate, by means of external clock pulses occurring at a second bit rate having any value from a number of different predetermined values, the phase differences between the internal clock pulses and the respective external clock pulses being measured by a measuring device (2, 3, 4) comprising a counter (2) which continually counts the internal clock pulses, a control device (6, 7) feeding to the oscillator (1) a control voltage corresponding to the respective phase difference between the internal and external clock pulses until a certain setting is reached such that the internal clock pulses generated by the oscillator (1) occur in a fixed phase relationship to the associated external clock pulses, characterised in that the positions ($Z1$, $Z2$) of the counter (2) at times establishing a given search transit time interval are logically combined and rounded up by the control device (6, 7) in accordance with the relation

$$m = n (Z2 - Z1)$$

where $Z1$ and $Z2$ denote the positions of the counter (2) at the beginning and end of the said search transit time interval, n denotes the number of external clock pulses establishing the next measuring time interval and m denotes the number of internal clock pulses occurring within the said measuring time interval, in that the position of the counter (2) at the beginning of the said measuring time interval is made available to the control circuit (6, 7) as a phase reference value and in that at times each following the latter time by an amount corresponding to the duration of the given measuring time interval the phase reference value increased by m in each case and then held in readiness as the current phase reference value is related to the position of the counter (2) then respectively occurring, the result thereof being used to deliver a control voltage of corresponding magnitude for the oscillator (1).

2. A method according to claim 1, characterised in that the respective calculated current phase reference value is subjected to subtraction with the respective counter position occurring.

3. A circuit arrangement for synchronising a voltage-controlled oscillator (1), more particularly an oscillator forming part of an exchange system and generating internal clock pulses at a first bit rate, by means of external clock pulses occurring at a second bit rate having any value from a number of different predetermined values, having a measuring device (2, 3, 4), comprising a counter (2) which continually counts the internal clock pulses, for the phase differences between the internal clock pulses and the respective external clock pulses, and having a control device (6, 7) feeding to the oscillator (1) a control voltage corresponding to the respective phase difference between the internal and external clock pulses, and so setting said oscillator that the internal clock pulses generated by the oscillator (1) occur in a fixed phase relationship to the respective external clock pulses, characterised in that the counter (2) is connected on the output side to a latch register device (3; 3a to 3d) which receives the positions of the counter (2) at times occurring successively in the spacing of the given time interval, in that the positions of the counter (2) at two such successive times are logically combined and rounded up in accordance with the relation

$$m = n (Z2 - Z1)$$

where $Z1$ and $Z2$ denote the positions of the counter (2) at the beginning and end of the said search transit time interval, n denotes the number of external clock pulses establishing the next measuring time interval and m denotes the number of internal clock pulses occurring within the said measuring time interval, in that the position of the counter (2) at the beginning of the said measuring time interval serves as a phase reference value for a phase evaluation value in which at further times respectively following by an amount corresponding to the duration of the said measuring time interval said phase reference value respectively increased by m is related to the position of the counter (2) then respectively occurring, and in that the result of this relation is used as adjustment variable for the oscillator (1).

4. A circuit arrangement according to claim 3, characterised in that the relation formed between the respectively occurring position of the counter (2) and the respective current calculated phase reference value is a subtraction.

**5.** A circuit arrangement according to claim 3 or 4, characterised in that the control device (6, 7) comprises a microprocessor or microcomputer (6) which, controlled by the external clock pulses, receives the positions of the counter (2) and controls the oscillator (1) on the output side via a digital/analog converter (7).

**6.** A circuit arrangement according to any one of claims 3 to 5, characterised in that a latch register device (3; 3a to 3d) is provided between the counter (2) and the control device (6, 7).

**7.** A circuit arrangement according to claim 6, characterised in that the latch register device (3; 3a to 3d) is connected to a bistable trigger (4) which receives on the input side both the internal and the external clock pulses.

**8.** A circuit arrangement according to claim 7, characterised in that the bistable trigger (4) is a D-trigger (4), the clock input of which receives the internal clock pulses and the D-input of which receives the external clock pulses.

**Revendications**

**1.** Procédé de synchronisation d'un oscillateur (1) commandé en tension appartenant en particulier à un équipement de commutation, oscillateur qui produit des impulsions internes de cadencement délivrées à un premier débit de chiffres binaires, avec l'aide d'impulsions externes de cadencement délivrées à un second débit de chiffres binaires, qui a une valeur quelconque choisie parmi un nombre de différentes valeurs prédéterminées, les différences de phase existant entre les impulsions internes de cadencement et les impulsions externes de cadencement respectives étant mesurées à l'aide d'une dispositif de mesure (2, 3, 4) comprenant un compteur (2) comptant en permanence les impulsions internes de cadencement et une tension de commande correspondant à la différence de phase respective entre les impulsions internes et externes de cadencement étant appliquée à l'oscillateur (1) au moyen d'un dispositif de commande (6, 7) à un réglage tel que les impulsions internes de cadencement produites par l'oscillateur (1) sont fournies dans une relation de phase déterminée avec les impulsions externes de cadencement correspondantes, caractérisé en ce que, à des moments définissant une période déterminée de recherche, les indications de comptage (Z1, Z2) du compteur (2) sont combinées et arrondies par le dispositif de commande (6, 7) selon la relation :

$$m = n (Z2 - Z1)$$

dans laquelle Z1 et Z2 représentent les indications de comptage du compteur (2) au début et à la fin de la période de recherche mentionnée, n est le nombre d'impulsions externes de cadencement définissant la période de mesure suivante et m le nombre d'impulsions internes de cadencement délivrées pendant la période de mesure mentionnée, en ce que l'indication de comptage du compteur (2) au début de la période de mesure mentionnée sert de valeur de référence de phase au dispositif de commande (6, 7) et en ce que, au moment mentionné ci-dessus, respectivement, à la durée des moments se succèdant dans l'intervalle de la période de mesure déterminée, la valeur de référence de phase augmentée de m respectivement et ensuite utilisée comme valeur de référence de phase actuelle est rapportée à l'indication de comptage du compteur (2) présente respectivement, le résultat de cette relation étant tiré pour la fourniture à l'oscillateur (1) d'une tension de commande correspondante à sa grandeur.

**2.** Procédé selon la revendication 1, caractérisé en ce que la valeur de référence de phase actuelle calculée respective est soumise à une soustraction avec l'indication de comptage présente correspondante.

**3.** Disposition de circuit pour la synchronisation d'un oscillateur (1) commandé en tension appartenant en particulier à un équipement de commutation, oscillateur qui produit des impulsions internes de cadencement délivrées à un premier débit de chiffes binaires, à l'aide d'impulsions externes de cadencement délivrées à un second débit de chiffres binaires, qui a une valeur quelconque choisie parmi un nombre de différentes valeurs prédéterminées, avec un dispositif de mesure (2, 3, 4) comprenant un compteur (2) comptant en permanence les impulsions internes de cadencement pour les différences de phase existantes entre les impulsions internes de cadencement et les impulsions externes de cadencement respectives et avec un dispositif de commande (6, 7) qui applique à l'oscillateur (1) une tension de commande correspondante à la différence de phase respective entre les impulsions internes et externes de cadencement et l'ajuste en sorte que les impulsions internes de cadencement produites par l'oscillateur (1) présentent une relation de phase définie avec les impulsions externes de cadencement, caractérisée en ce que le compteur (2) est relié du côté de sa sortie à un agencement à registre de verrouillage (3, 3a à 3d) qui reçoit les indications de comptage du compteur (2) présentes aux moments se succédant par intervalles dans la période déterminée, en ce que les indications de comptage du compteur (2) présentes dans deux de ces moments successifs sont combinées et arrondies selon la relation :

$$m = n \, (Z2 - Z1)$$

dans laquelle Z1 et Z2 représentent les indications de comptage du compteur (2) au début et à la fin de la période de recherche mentionnée, n représentant le nombre d'impulsions externes de cadencement définissant la période de mesure suivante et m le nombre d'impulsions internes de cadencement délivrées dans la période de mesure mentionnée, en ce que l'indication de comptage du compteur (2) obtenue au début de la période de mesure mentionnée sert de valeur de référence de phase pour une évaluation de la phase, dans laquelle, respectivement, aux autres moments successifs de la durée de la période de mesure mentionnée, cette valeur de référence de phase respectivement augmentée de m est rapportée à l'indication de comptage du compteur (2) respectivement présente ensuite et en ce que le résultat de cette relation sert de grandeur de réglage pour l'oscillateur (1).

4. Disposition de circuit selon la revendication 3 caractérisée en ce que la relation établie entre respectivement l'indication de comptage du compteur (2) présente et la valeur de référence de phase calculée actuelle est une soustraction.

5. Disposition de circuit selon la revendication 3 ou 4, caractérisée en ce que le dispositif de commande (6, 7) contient un microprocesseur ou un micro-ordinateur (6) qui, commandé par les impulsions externes de cadencement, reçoit les indications de comptage du compteur (2) et commande du côté de la sortie l'oscillateur (1) par l'intermédiaire d'un convertisseur numérique/analogique (7).

6. Disposition de circuit selon les revendications 3 à 5, caractérisée en ce qu'un dispositif à registre de verrouillage (3, 3a à 3d) est prévu entre le compteur (2) et le dispositif de commande (6, 7).

7. Disposition de circuit selon la revendication 6, caractérisée en ce que le dispositif à registre de verrouillage (3, 3a à 3d) est relié à une bascule bistable (4) qui reçoit du côté de l'entrée aussi bien les impulsions internes de cadencement que les impulsions externes de cadencement.

8. Disposition de circuit selon la revendication 7, caractérisée en ce que la bascule bistable (4) est une bascule D à l'entrée de cadencement de laquelle sont acheminées les impulsions internes de cadencement et à l'entrée D de laquelle sont acheminées les impulsions externes de cadencement.

Fig. 1